# EUROPÄISCHE PATENTSCHRIFT

(11) **EP 2 844 927 B1**
(45) Veröffentlichungstag und Bekanntmachung des Hinweises auf die Patenterteilung: **12.09.2018**
(21) Anmeldenummer: 13719835.4
(22) Anmeldetag: 29.04.2013
(51) Int. Cl.: H05K 7/20, F24H 1/14, F24H 9/00, F24H 9/18

(54) **HEIZVORRICHTUNG FÜR EIN FAHRZEUG UND VERFAHREN ZUM KÜHLEN EINER ELEKTRONISCHEN STEUEREINRICHTUNG DER HEIZVORRICHTUNG**
HEATING DEVICE FOR VEHICLE AND METHOD TO COOL AN ELECTRONIC CONTROL DEVICE OF SAID HEATING DEVICE
DISPOSITIF DE CHAUFFAGE POUR VÉHICULE ET MÉTHODE POUR REFROIDIR UNE UNITÉ DE CONTRÔLE ÉLECTRONIQUE DUDIT DISPOSITIF DE CHAUFFAGE

(30) Priorität: 02.05.2012 DE 102012207301
(43) Veröffentlichungstag der Anmeldung: 11.03.2015
(73) Patentinhaber: Webasto SE, 82131 Stockdorf (DE)
(72) Erfinder: REINHOLZ, Uwe, 14532 Stahnsdorf (DE); LARISCH, Florian, 82299 Zankenhausen (DE); GÖTTL, Karl, 83026 Rosenheim (DE); STAAKE, Michael, 82131 Stockdorf (DE); BUCKL, Stephan, 81243 München (DE); ELM, Nils, 82205 Gilching (DE); KABELITZ, Thorsten, 81673 München (DE)
(74) Vertreter: Schumacher & Willsau
(86) Internationale Anmeldenummer: PCT/EP2013/058918
(87) Internationale Veröffentlichungsnummer: WO 2013/164313

(56) Entgegenhaltungen:
- WO-A1-99/40375
- WO-A1-2011/129201

## Beschreibung

Die Erfindung betrifft eine Heizvorrichtung für ein Fahrzeug.

Elektrische Heizvorrichtungen finden beispielsweise in Kraftfahrzeugen als Zusatzheizung oder Standheizung Anwendung. Eine elektrische Heizvorrichtung weist üblicherweise mindestens eine elektrische Heizeinrichtung zum Erzeugen von Wärme und zur Abgabe von erzeugter Wärme an ein Wärmetransportmittel auf. Das Wärmetransportmittel kann beispielsweise Wasser oder eine andere geeignete Wärmetransportflüssigkeit sein. Die elektrische Heizeinrichtung kann mit einer elektronischen Steuereinrichtung verbunden sein, die es erlaubt, die Heizleistung der Heizeinrichtung zu steuern. Die elektronische Steuereinrichtung kann beispielsweise ein Leistungstransistor oder ein elektronischer Schaltkreis auf Halbleitergrundlage sein, beispielsweise zum Steuern eines elektrischen Stroms in der Heizeinrichtung oder zum Steuern einer an der Heizeinrichtung anliegenden Spannung.

Die WO 99/40375 A1 beschreibt einen Durchlauferhitzer mit einem Vorheizabschnitt und mehreren nachgeordneten Behältnissen zwischen denen ein innerer Rückfluss vorgesehen ist.

Die WO 2011/129201 A1 beschreibt ein Fluidheizgerät, bei dem auf einer Vorderseite und auf einer Rückseite eines PTC-Heizelementes jeweils Strömungspfade für ein zu erwärmendes Fluid vorgesehen sind.

Die elektronische Steuereinrichtung erzeugt als Nebeneffekt typischerweise Wärme, die als Abwärme abgeführt werden muss, damit die Steuereinrichtung nicht überhitzt. Beispielsweise kann eine Luftkühlung vorgesehen sein, die es erlaubt, die Abwärme über zugeführte Luft abzuführen. Die elektronische Steuereinrichtung kann beispielsweise in einem Luftkanal angeordnet sein, der von Luft durchströmbar ist. Innerhalb des Kanals kann ein Gebläse, zum Beispiel ein Ventilator, angeordnet sein, um einen Luftstrom zu erzeugen. Die von der elektronischen Heizvorrichtung vorgewärmte Luft kann weiter durch die Heizvorrichtungen geführt werden, um sie weiter auf die gewünschte Temperatur zu erhitzen. Die erhitzte Luft kann anschließend an ihren Bestimmungsort weitergeleitet werden, zum Beispiel in eine Fahrgastzelle eines Fahrzeugs.

Der Erfindung liegt die Aufgabe zugrunde, eine möglichst kompakte, robuste, energiesparende und bautechnisch einfache elektrische Heizvorrichtung zu schaffen. Der Erfindung liegt ferner die Aufgabe zugrunde, ein energieeffizientes und konstruktionstechnisch einfach zu realisierendes Verfahren zur Kühlung einer elektrischen Steuereinrichtung einer Heizvorrichtung anzugeben.
Die Aufgaben werden durch die Merkmale des unabhängigen Anspruchs gelöst. Die abhängigen Ansprüche beschreiben Weiterbildungen und vorteilhafte Ausführungsformen.
Nachfolgend wird eine Heizvorrichtung für ein Fahrzeug beschrieben, mit einem Strömungsweg für ein flüssiges Wärmetransportmittel, einer elektrischen Heizeinrichtung zum Erzeugen von Wärme und zur Abgabe von erzeugter Wärme an das Wärmetransportmittel auf einem Heizabschnitt des Strömungsweges und mit einer elektronischen Steuereinrichtung zum Steuern einer Heizleistung der Heizeinrichtung.

Die Steuereinrichtung ist mit einem Wärmeabgabekörper versehen, zur Abgabe von Abwärme der Steuereinrichtung an das Wärmetransportmittel auf einem Vorheizabschnitt des Strömungsweges stromaufwärts des Heizabschnittes. Die Abwärme der elektronischen Steuereinrichtung wird demnach größtenteils nicht direkt an das zu erwärmende "Zielmedium" (zum Beispiel Luft zur Versorgung einer Fahrgastzelle des Fahrzeugs) übertragen, sondern auf das flüssige Wärmetransportmittel. Das hierfür benötigte Bauvolumen kann zum Beispiel im Vergleich zu einer Luftkühlung der elektronischen Steuereinrichtung geringer sein. Ein Luftkanal oder sonstige Bauelemente zur Definition eines Luftströmungsweges innerhalb der Heizvorrichtung und ein Gebläse können entfallen. Der Wärmeabgabekörper kann beispielsweise innerhalb einer Einlasskammer für das Wärmetransportmittel oder innerhalb eines sonstigen dem Heizabschnitt vorgelagerten Strömungsbereichs des Wärmetransportmittels angeordnet sein. Durch eine geeignete Dimensionierung und geometrische Form des Wärmeabgabekörpers kann in Verbindung mit einer geeigneten Strömungsgeschwindigkeit des Wärmetransportmediums eine ausreichend hohe Wärmeübertragung von der elektronischen Steuereinrichtung über den Wärmeabgabekörper auf das Wärmetransportmedium sichergestellt werden. Auf die Weise lässt sich verhindern, dass das an dem Wärmeabgabekörper vorbeiströmende Wärmetransportmedium, zum Beispiel Wasser, anfängt zu sieden. Ein Sieden des Wärmetransportmediums an dem Wärmeabgabekörper kann unerwünscht sein, da sich hierdurch an dem Wärmeabgabekörper Blasen bilden können, die thermisch isolierend wirken können und damit die Abführung der Abwärme der elektronischen Steuereinrichtung behindern können. Durch eine geeignete Dimensionierung und Gestaltung des Wärmeabgabekörpers kann jedoch zumindest erreicht werden, dass selbst im Falle eines Siedens des Wärmetransportmediums an den Wärmeabgabekörper entstehende Blasen mit dem strömenden Wärmetransportmedium weggespült werden. Es kann daher vorteilhaft sein, dass der Wärmeabgabekörper eine glatte (nicht raue) und/oder eine stromlinienförmige Oberfläche aufweist. Eine raue, unebene und nicht stromlinienförmige Oberfläche kann zwar den Vorteil bieten, dass an der Oberfläche Turbulenzen des Wärmetransportmediums erzeugt werden, die für den Wärmefluss von dem Wärmeabgabekörper in das Wärmetransportmedium günstig sind, doch können sie im Falle eines Siedens des Wärmetransportmediums dazu führen, dass entstehende Blasen an dem Wärmeabgabekörper hängen bleiben. Ist jedoch das Risiko eines Siedens vernachlässigbar, so kann eine turbulenzfördernde Gestaltung der Oberfläche des Wärmeabgabekörpers die vorteilhaftere Option sein.

Die Heizvorrichtung kann mit einem Luftwärmetauscher zur Übertragung von Wärme von dem Wärmetransportmittel stromabwärts des Heizabschnittes auf Luft ausgestattet sein. Der Luftwärmetauscher kann beispielweise mehrere Kanäle für das Wärmetransportmittel und mehrere Kanäle für die Luft aufweisen, die zueinander benachbart angeordnet sind, um einen möglichst guten Wärmeübergang auf die Luft zu gewährleisten.

Die Heizvorrichtung kann eine Wand aufweisen, die den Strömungsweg in dem Vorheizabschnitt wenigstens teilweise definiert, wobei sich der Wärmeabgabekörper von der Wand ausgehend in den Vorheizabschnitt hineinerstreckt. Der Wärmeabgabekörper kann beispielsweise als ein Vorsprung der Wand oder als Stift, Bolzen oder Rippe ausgestaltet sein.

Es kann vorgesehen sein, dass sich der Wärmeabgabekörper bis zu einem gegenüberliegenden Teil der Wand erstreckt. Das in dem Vorheizabschnitt zur Verfügung stehende Volumen kann auf die Weise optimal genutzt werden. Der Wärmeabgabekörper kann zum Beispiel zwei Enden aufweisen, die an gegenüberliegenden Seiten der Wand befestigt sind. Diese Anordnung kann besonders robust sein. An jedem der beiden Enden kann eine elektronische Steuereinrichtung angeordnet sein, sofern die Heizvorrichtung mehrere elektronische Steuereinrichtungen aufweist. Die Heizvorrichtung kann beispielsweise mehrere elektrische Heizeinrichtungen, zum Beispiel mehrere parallel geschaltete Heizwiderstände aufweisen, denen jeweils eine elektronische Steuereinrichtung, zum Beispiel ein Leistungsschalter, zugeordnet ist.

Der Wärmeabgabekörper und die Wand können aus einem Stück sein. Dies kann die Fertigung der Heizvorrichtung erleichtern und eine hohe Robustheit sicherstellen. Der Wärmeabgabekörper und die Wand können beispielsweise als ein Formteil aus einem geeigneten möglichst gut wärmeleitenden Material hergestellt sein. Alternativ kann der Wärmeabgabekörper zum Beispiel aus einem möglichst gut wärmeleitenden Material, zum Beispiel einem Metall, zum Beispiel Aluminium, und die Wand aus einem thermisch möglichst gut isolierenden Material, zum Beispiel einem Kunststoff oder Keramik, hergestellt sein. Hierdurch kann zum einen der Wärmeübergang zwischen dem Wärmeabgabekörper und dem Wärmetransportmittel optimiert werden und zum anderen der Verlust von Wärme über die Wand an benachbarte Bauteile oder eine sonstige Umgebung, zum Beispiel Luft, der Heizvorrichtung minimiert werden.

Wie schon erwähnt, kann die Heizvorrichtung eine zweite elektronische Steuereinrichtung aufweisen, wobei sich der Wärmeabgabekörper von der ersten Steuereinrichtung bis zu der zweiten Steuereinrichtung erstreckt. Bildlich gesprochen teilen sich in diesem Fall die erste Steuereinrichtung und die zweite Steuereinrichtung einen gemeinsamen Wärmeabgabekörper. Die Herstellungskosten können auf die Weise reduziert und die Robustheit erhöht werden.

Die Heizvorrichtung kann ferner einen Wärmeübertrager zur Übertragung von Wärme von der Heizeinrichtung auf das Wärmetransportmittel in dem Heizabschnitt aufweisen. Alternativ ist denkbar, dass die elektrische Heizeinrichtung unmittelbar mit dem Wärmetransportmittel in Kontakt steht.

Erfindungsgemäß sind der Wärmeübertrager und der Wärmeabgabekörper aus einem Stück. Das den Wärmeübertrager und den Wärmeabgabekörper enthaltende Bauteil kann zum Beispiel eine erste Gruppe von Rippen und eine zweite Gruppe von Rippen aufweisen, wobei jede Gruppe mindestens eine Rippe enthält und die erste Gruppe innerhalb des Heizabschnitts des Strömungsweges angeordnet ist, während die zweite Gruppe innerhalb des Vorheizabschnittes des Strömungsweges angeordnet ist. Das heißt, die erste Gruppe von Rippen kann als der Wärmeübertrager oder als Teil des Wärmeübertragers aufgefasst werden, während die zweite Gruppe von Rippen als der Wärmeabgabekörper oder als Teil des Wärmeabgabekörpers aufgefasst werden kann. Benachbarte Rippen können beispielsweise einen Kanal für das Wärmetransportmittel definieren, welcher Teil des Strömungsweges ist.

Die Heizvorrichtung kann ferner ein Verbindungsstück aufweisen, welches den Wärmeübertrager und den Wärmeabgabekörper miteinander verbindet und sich entlang eines nicht geraden Weges erstreckt, so dass der Wärmewiderstand zwischen dem Wärmeübertrager und dem Wärmeabgabekörper im Vergleich zu einem kürzesten Weg erhöht ist. Der Wärmefluss von der elektrischen Heizeinrichtung zu der elektronischen Steuereinrichtung kann auf die Weise minimiert werden. Das Verbindungsstück kann beispielsweise als eine Sicke oder als mehrere aufeinanderfolgende Sicken ausgeführt sein.

Der erwähnte nicht gerade Weg kann zum Beispiel die Form eines der folgenden Buchstaben haben: L, U, V, S, Z, N, M und W.

Der Wärmeabgabekörper kann derart ausgerichtet sein, dass sein Strömungswiderstand für das Wärmetransportmittel minimal ist. Die für das Bewegen des Wärmetransportmittels entlang des Strömungswegs erforderliche Leistung, also die für das Erzeugen der Strömung des Wärmeabgabekörpers erforderliche Leistung, kann auf die Weise minimiert werden. Wird für den Antrieb des Wärmetransportmittels zum Beispiel eine Pumpe verwendet, so kann eine Pumpe mit relativ geringer Leistung und damit relativ geringem Energieverbrauch verwendet werden. Zudem kann auf die Weise die Gefahr von Blasenbildung an dem Wärmeabgabekörper reduziert werden.

Wie erwähnt, kann die Steuereinrichtung zum Beispiel ein Leistungstransistor sein oder einen Leistungstransistor als wesentliches Element enthalten. Der Leistungstransistor kann elektrisch in Reihe mit einem Heizwiderstand der Heizeinrichtung geschaltet sein. Der Leistungsschalter kann beispielsweise ein Bipolartransistor mit isolierter Gate-Elektrode (IGPT) sein.

Auf dem Wärmeabgabekörper kann eine elektrisch isolierende Isolationsschicht und auf der Isolationsschicht eine elektrisch leitende Leitschicht jeweils unmittelbar aufgetragen sein, und die Steuereinrichtung kann auf der Leitschicht befestigt sein. Die elektrisch leitende Leitschicht begünstigt eine schnelle Dissipation der Abwärme der Steuereinrichtung. Ferner kann sie zur elektrischen Kontaktierung der Steuereinrichtung genutzt werden und ermöglicht eine elektrische Kontaktierung der elektronischen Steuereinrichtung, zum Beispiel zum Anlegen einer Steuerspannung. Die Isolationsschicht isoliert die Leitschicht elektrisch von dem Wärmeabgabekörper. Dies erlaubt es, den Wärmeabgabekörper ganz oder teilweise aus einem elektrisch leitenden Material, zum Beispiel einem Metall, zu fertigen.

Die Steuereinrichtung kann auf der elektrisch leitenden Leitschicht zum Beispiel über wenigstens eine Lötkugel, ein Klebelement, ein graphithaltiges Material, eine Wärmeleitfolie, eine Klemmverbindung oder eine Schraubverbindung befestigt sein. Die genannten Befestigungselemente können hinreichend flexibel sein, um thermischen Verspannungen Rechnung zu tragen.

Es zeigen:
- Figur 1: eine schematische Schrägansicht einer Heizvorrichtung;
- Figur 2: eine schematische Draufsicht der Heizvorrichtung aus Figur 1;
- Figur 3: eine schematische Seitenansicht einer elektronischen Steuereinrichtung, einem Wärmeabgabekörper und einem Wärmeübertrager;
- Figur 4: eine schematische Schnittansicht der Heizvorrichtung gemäß einer ersten Variante;
- Figur 5: eine schematische Schnittansicht der Heizvorrichtung gemäß einer zweiten Variante;
- Figur 6: eine schematische Schnittansicht einer elektronischen Steuereinrichtung mit einem Wärmeabgabekörper; und
- Figur 7: ein Flussdiagramm.

Bei der nachfolgenden Beschreibung der Zeichnungen bezeichnen gleiche Bezugszeichen gleiche oder vergleichbare Komponenten.

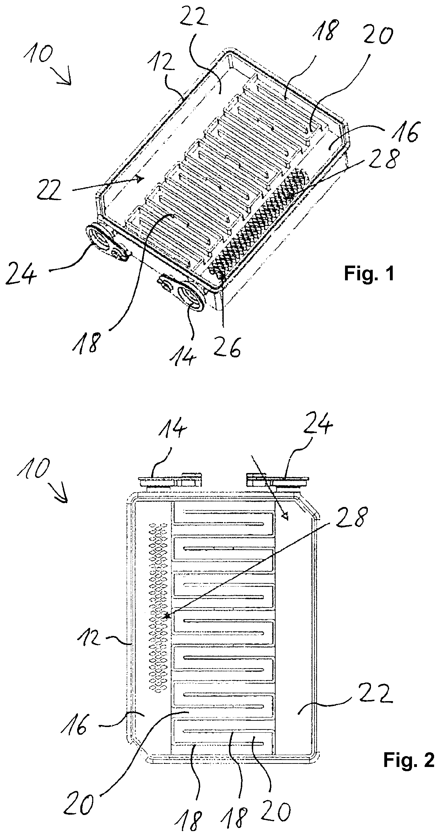

Figur 1 und Figur 2 zeigen eine elektrische Heizvorrichtung 10 für ein Fahrzeug, zum Beispiel für ein Kraftfahrzeug oder einen mobilen Wohn- oder Arbeitscontainer. Die Vorrichtung 10 ist nach oben hin offen dargestellt, um den Blick in einen Innenbereich der Vorrichtung 10 freizugeben. Die Heizvorrichtung 10 weist ein Gehäuse 12 auf. Innerhalb des Gehäuses 12 ist ein Strömungsweg für ein flüssiges Wärmetransportmittel, zum Beispiel Wasser, definiert. In dem gezeigten Beispiel umfasst der Strömungsweg die folgenden Abschnitte in dieser Reihenfolge: einen Einlass 14, eine Einlasskammer 16, mehrere durch einen Wärmeübertrager 18 definierte Kanäle 20, eine Auslasskammer 22 sowie einen Auslass 24. Die Kanäle 20 sind in strömungstechnischer Hinsicht parallel zueinander geschaltet und verbinden die Einlasskammer 16 mit der Auslasskammer 22.

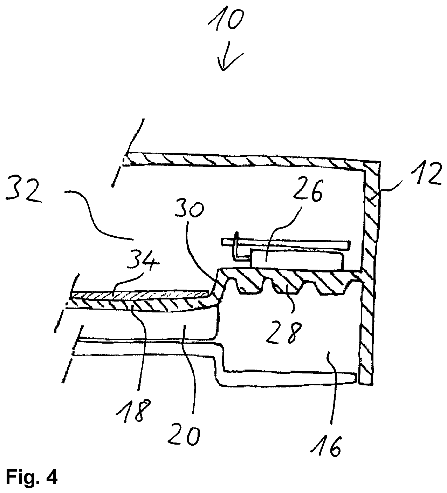

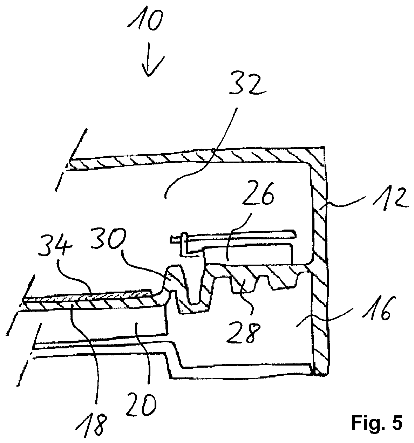

Mindestens eine Heizeinrichtung 34 (gezeigt in Figur 4 und Figur 5) ist in den Wärmeübertrager 18 integriert oder auf oder unter dem Wärmeübertrager 18 angeordnet und mit dem Wärmeübertrager 18 mechanisch derart verbunden, dass der Wärmewiderstand zwischen der Heizeinrichtung 34 und dem Wärmeübertrager 18 möglichst gering ist. In dem gezeigten Beispiel umfasst die Heizvorrichtung 10 eine Vielzahl von elektrischen Heizeinrichtungen 34 (dargestellt in Figur 4 und Figur 5) und eine entsprechende Anzahl an elektronischen Steuereinrichtungen 26 (ebenfalls in Figur 4 und Figur 5 schematisch dargestellt) zum Steuern der individuellen Heizleistung einer jeden der Heizeinrichtungen 34. Jeder Heizeinrichtung 34 ist somit eine elektronische Steuereinrichtung 26 zugeordnet. Die Heizeinrichtung 34 kann ein oder mehrere Heizelemente aufweisen. Die Heizeinrichtung 34 und die Steuereinrichtung 26 können beispielsweise ein Heizwiderstand und ein in Reihe mit dem Heizwiderstand geschalteter Leistungstransistor sein. Alternativ kann einer Gruppe von mehreren Heizeinrichtungen 34 eine gemeinsame Steuereinrichtung 26 zugeordnet sein. Zum Beispiel ist eine Ausführungsform denkbar, bei der die Gruppe alle Heizeinrichtungen 34 der Heizvorrichtung 10 umfasst und diese Gruppe mit einem Leistungsschalter 26 in Reihe geschaltet ist, um die Gesamtleistung der Heizeinrichtungen 34 zu steuern. Sind mehrere Steuereinrichtungen 26 vorgesehen, so können diese in einer gemeinsamen Baueinheit ausgeführt sein.

Jede der Steuereinrichtungen 26 ist mechanisch mit einem Wärmeabgabekörper 28 verbunden. Der Wärmeabgabekörper 28 dient der Ableitung von Abwärme der elektronischen Steuereinrichtung 26 an das Wärmetransportmittel in der Einlasskammer 16. Die Einlasskammer 16 wird deshalb auch als Vorheizabschnitt des Strömungsweges bezeichnet. Jeder Steuereinrichtung 26 können ein oder aber mehrere Wärmeabgabekörper 28 zugeordnet sein. Alternativ können die mehreren Wärmeabgabekörper 28 als ein gemeinsamer größerer Wärmeabgabekörper aufgefasst werden. In dem gezeigten Beispiel ragen die Wärmeabgabekörper 28 ausgehend von den Steuereinrichtungen 26 in die Einlasskammer 16 und werden im Betrieb der Heizungsvorrichtung 10 von dem Wärmetransportmittel umspült, wobei Wärme von den Wärmeabgabekörpern 28 auf das Wärmetransportmittel übertragen wird. Die Wärmeabgabekörper 28 und damit die Steuereinrichtungen 26 werden somit gekühlt, während das Wärmetransportmittel vorgewärmt wird. Das vorgewärmte Wärmetransportmittel strömt von der Einlasskammer 16 aus weiter durch die Kanäle 20. Dabei strömt es an dem die Kanäle 20 definierenden Wärmeübertrager 18 entlang und nimmt dabei von den Heizeinrichtungen 34 erzeugte Wärme auf. Jeder der Kanäle 20 oder die Kanäle 20 gemeinsam werden deshalb auch als Heizabschnitt des Strömungsweges bezeichnet. Das somit erhitzte Wärmetransportmedium strömt dann weiter durch die Auslasskammer 22 und verlässt die Heizvorrichtung 10 durch den Auslass 24.

Die Wärmeabgabekörper 28 können beispielsweise jeweils als Rippe mit zum Beispiel rechteckigem oder V-förmigem Querschnitt ausgestaltet sein, um die Wärme von der Steuereinrichtung, zum Beispiel dem Leistungshalbleiter, in das Wärmetransportmittel abzuleiten. Der Wärmeabgabekörper 28 kann damit gleichzeitig zur Lenkung des Wärmetransportmittels verwendet werden. Alternativ kann der Wärmeabgabekörper 28 beispielsweise ein Zapfen, ein Bolzen oder ein Stift sein, um punktuell die Wärme unter der jeweiligen Steuereinrichtung, zum Beispiel unter einer relativ kleinen Chipfläche, abzuleiten. Ein solcher Zapfen, Bolzen oder Stift kann ferner zu einer verbesserten Verwirbelung des Wärmetransportmittels und damit einer erhöhten Wärmeabführung beitragen. Eine Überhitzung der elektronischen Steuereinrichtung kann damit vermieden werden und die Abwärme der Steuereinrichtung wird auch zum Erwärmen des Wärmetransportmediums genutzt.

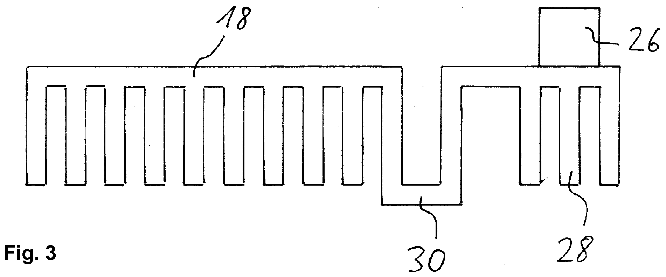

Figur 3 zeigt schematisch eine Seitenansicht eines Beispiels des Wärmeübertragers 18, der Steuereinrichtung 26 und des Wärmeabgabekörpers 28. In dem gezeigten Beispiel umfassen der Wärmeübertrager 18 und der Wärmeabgabekörper 28 jeweils eine Gruppe bestehend aus mehreren Rippen, die auch als Kühlrippen gekannt sind und der möglichst schnellen Übertragung von Wärme auf das Wärmetransportmittel auf dem Heizabschnitt beziehungsweise dem Vorheizabschnitt des Strömungsweges dienen. Die Steuereinrichtung 26, die zum Beispiel ein Halbleiterchip ist, kann an dem Wärmeabgabekörper 28 befestigt sein. In dem gezeigten Beispiel sind der Wärmeübertrager 18 und der Wärmeabgabekörper 28 aus einem Stück. Sie sind über ein Verbindungsstück 30 miteinander verbunden, welches entlang eines nicht geraden Weges verläuft. Hierdurch wird ein Kompromiss zwischen möglichst einfacher Fertigung und hoher Robustheit einerseits und guter thermischer Isolation zwischen dem Wärmeübertrager 18 und dem Wärmeabgabekörper 28 erreicht. Es ist wünschenswert, dass der Wärmeabgabekörper 28 von dem Wärmeübertrager 18 thermisch möglichst gut isoliert ist, zumindest dann, wenn die mit dem Wärmeübertrager 18 in thermischem Kontakt stehende Heizeinrichtung 34 (siehe Figur 4 und 5) eine höhere Betriebstemperatur erreichen soll als die Steuereinrichtung 26. Das Verbindungsstück 30 ist in dem gezeigten Beispiel im Wesentlichen U-förmig. Das Verbindungsstück 30 hat im Vergleich zu einem hypothetischen geraden Verbindungsstück bei gleicher Distanz der Endpunkte eine größere Länge und damit einen größeren Wärmeübergangswiderstand, wodurch die Erwärmung der elektronischen Steuereinrichtung reduziert wird. Der Wärmeübertrager 18 und der Wärmeabgabekörper 28 sind damit zu einem gewissen Grade voneinander thermisch entkoppelt. In anderen Worten: bei gleichem möglichst geringem geometrischen Abstand zwischen dem Wärmeübertrager 18 und dem Wärmeabgabekörper 28 hat das nicht gerade Verbindungsstück 30 im Vergleich zu einem ebenfalls denkbaren geraden Verbindungsstück einen geringeren Wärmestrom von der Heizeinrichtung 34 zu der Steuereinrichtung 26 zur Folge. Es ergibt sich somit eine kompakte Bausweise, bei der der Wärmeübertrager 18 (Heizungswärmeübertrager) und der Wärmeabgabekörper 28 (Elektronikwärmeübertrager) in einem Bauteil ausgeführt werden können, ohne dass die elektronische Steuereinrichtung 26 von der Heizeinrichtung 34 zu sehr erwärmt wird.

Figur 4 zeigt eine Ausführungsform der Heizvorrichtung 10, bei der der Wärmeübertrager 18 und der Wärmeabgabekörper 28 über ein geradliniges Verbindungsstück 30 miteinander verbunden sind.

Die in Figur 5 schematisch dargestellte Ausführungsform unterscheidet sich davon nur dadurch, dass das Verbindungsstück 30 nichtgerade, zum Beispiel S-förmig, gestaltet ist, um bei dem gleichen Gesamtvolumen der Heizvorrichtung 10 eine bessere thermische Isolierung zwischen dem Wärmeübertrager 18 und dem Wärmeabgabekörper 28, und damit zwischen der Heizeinrichtung 34 und der Steuereinrichtung 26, zu erreichen.

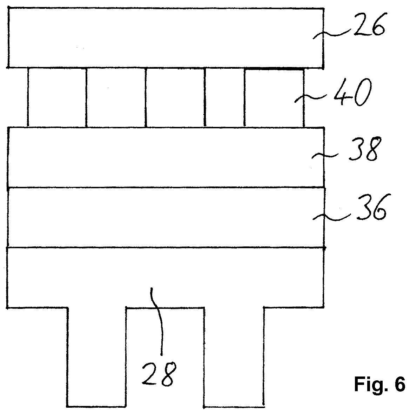

Um eine möglichst rasche Ableitung der Abwärme der Steuereinrichtung 26 über dem Wärmeabgabekörper 28 zu erreichen, wird vorgeschlagen, die Steuereinrichtung 26 stoffschlüssig an dem Wärmeabgabekörper 28 anzubinden. Figur 6 zeigt schematisch ein Beispiel einer möglichen Art der Anbindung der elektronischen Steuereinrichtung 26 an den Wärmeabgabekörper 28. Auf den Wärmeabgabekörper 28 ist unmittelbar eine elektrisch isolierende Isolationsschicht 36 aufgetragen oder aufgespritzt. Die Isolationsschicht 36 kann beispielsweise mittels eines thermischen Spritzverfahrens direkt auf den Wärmeabgabekörper 28 aufgebracht werden. Das Material der Isolationsschicht kann beispielsweise ein gefüllter Kunststoff, Glas oder Keramik, zum Beispiel Al2O3, sein. Die elektrisch isolierende Isolationsschicht 36 sollte thermisch möglichst gut leiten.

Auf die Isolationsschicht 36 ist unmittelbar eine elektrisch leitende Leitungsschicht aufgetragen. Die Leitungsschicht 38 kann eine Wärmespreizung und damit eine bessere Kühlung der Steuereinrichtung 26 bewirken. Sie kann beispielsweise aus einem Phasenwechsel-Material bestehen. Das Material der Leitungsschicht kann zum Beispiel Kupfer sein. Die Leitungsschicht 38 kann durch ein thermisches Spritzverfahren oder ein anderes Beschichtungsverfahren auf die Isolationsschicht 36 aufgetragen werden. Die Leitungsschicht 38 kann außerdem dazu genutzt werden, um eine Versorgungs- oder Steuerspannung an die elektrische Steuereinrichtung 26 anzulegen. Die elektronische Steuereinrichtung, zum Beispiel in Form eines Chips, ist in dem gezeigten Beispiel über mehrere (zum Beispiel drei) Lötkugeln auf die Leitungsschicht 38 aufgelötet. Alternativ kann die Steuereinrichtung 26, zum Beispiel über ein thermisch leitendes Klebesystem, ein graphithaltiges Material, eine Wärmeleitfolie, Klemm- oder Schraubverbindungen, oder durch eine Kombination dieser Mittel angebracht sein. Die Dicke der Schichten 36 und 28 kann zum Beispiel jeweils etwas 100 Mikrometer betragen.

Aufwendige Mehrschichtsysteme und Fügeverfahren können so vermieden werden. Material und Kosten können reduziert beziehungsweise optimiert werden. Der schlanke Aufbau kann zudem besonders platzsparend sein. Der vorgeschlagene Aufbau eignet sich besonders für einen automatischen Fertigungsprozess.

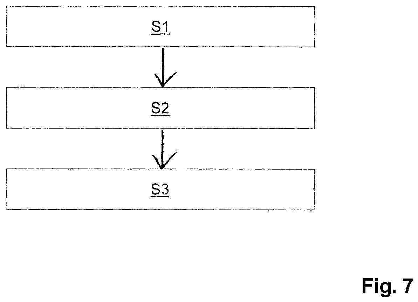

Das Flussdiagramm in Figur 7 veranschaulicht einen Betrieb der Heizvorrichtung 10, in dem die elektrische Steuereinrichtung 26 gekühlt wird. In Block S1 wird die Heizvorrichtung 10 eingeschaltet. Zum Beispiel kann eine Pumpe (nicht gezeigt) eingeschaltet werden, um das Wärmetransportmittel entlang des Strömungsweges zu bewegen. Gleichzeitig oder vorher oder nachher kann die elektronische Steuereinrichtung 26 derart betätigt werden, dass die Heizeinrichtung 34 bestromt wird, um Wärme zu erzeugen.

Die elektrische Heizeinrichtung 34 gibt folglich Heizwärme an das Wärmetransportmittel in dem Heizabschnitt des Strömungsweges ab (Block S2). Zuvor nimmt das an dem Wärmeabgabekörper 28 entlangströmende und ihn umströmende Wärmetransportmittel Abwärme der Steuereinrichtung 26 über den Wärmeabgabekörper 28 auf, wodurch die Steuereinrichtung 26 gekühlt und das Wärmetransportmittel vorgewärmt wird.

In Block S3 wird die Heizvorrichtung 10 ausgeschaltet.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

"Steuern" bedeutet das kontrollierte Ändern eines Zustands, zum Beispiel eine kontrollierte Änderung des Wertes einer physikalischen Größe oder eine kontrollierte Beeinflussung eines Bauelementes. "Regeln" bedeutet Steuern mit Rückkopplung, das heißt, die kontrollierte Änderung eines Zustands in Abhängigkeit von dem Zustand selbst. "Regeln" wird somit als eine besondere Art des Steuerns angesehen. Jedes in dieser Anmeldung erwähnte Steuern kann ein Steuern mit Rückkopplung, also ein Regeln sein. Insbesondere kann die Steuereinrichtung 26 eine Regeleinrichtung sein.

### Bezugszeichenliste

- 10: Vorrichtung
- 12: Gehäuse
- 14: Einlass
- 16: Einlasskammer
- 20: Kanäle
- 22: Auslasskammer
- 24: Auslass
- 26: Steuereinrichtung
- 28: Wärmeabgabekörper
- 30: Verbindungsstück
- 34: Heizeinrichtung
- 36: Isolationsschicht
- 38: Leitungsschicht
- 40: Lötkugel

## Patentansprüche

1. Heizvorrichtung (10) für ein Fahrzeug, mit:
- einem Strömungsweg (14, 16, 20, 22, 24) für ein flüssiges Wärmetransportmittel;
- einer elektrischen Heizeinrichtung (34) zum Erzeugen von Wärme und einem Wärmeübertrager (18) zur Übertragung von Wärme von der Heizeinrichtung (34) an das Wärmetransportmittel auf einem Heizabschnitt (20) des Strömungsweges; und
- einer elektronischen Steuereinrichtung (26) zum Steuern einer Heizleistung der Heizeinrichtung, wobei die Steuereinrichtung (26) mit einem Wärmeabgabekörper (28) versehen ist, zur Abgabe von Abwärme der Steuereinrichtung (26) an das Wärmetransportmittel auf einem Vorheizabschnitt (16) des Strömungsweges stromaufwärts des Heizabschnittes (20);
**dadurch gekennzeichnet, dass** der Wärmeübertrager (18) und der Wärmeabgabekörper (28) aus einem Stück sind.

2. Heizvorrichtung (10) nach Anspruch 1, mit einem Luftwärmetauscher zur Übertragung von Wärme von dem Wärmetransportmittel stromabwärts des Heizabschnittes (20) auf Luft.

3. Heizvorrichtung (10) nach Anspruch 1 oder 2, mit einer den Strömungsweg in dem Vorheizabschnitt (16) wenigstens teilweise definierenden Wand, wobei sich der Wärmeabgabekörper (28) von der Wand ausgehend in den Vorheizabschnitt (16) hineinerstreckt.

4. Heizvorrichtung (10) nach Anspruch 3, wobei sich der Wärmeabgabekörper (28) bis zu einem gegenüberliegenden Teil der Wand erstreckt.

5. Heizvorrichtung (10) nach Anspruch 3 oder 4, wobei der Wärmeabgabekörper (28) und die Wand aus einem Stück sind.

6. Heizvorrichtung (10) nach einem der vorangehenden Ansprüche, mit einer zweiten elektronischen Steuereinrichtung (26), wobei sich der Wärmeabgabekörper (28) von der ersten Steuereinrichtung (26) bis zu der zweiten Steuereinrichtung (26) erstreckt.

7. Heizvorrichtung (10) nach Anspruch 5 oder 6, mit einem Verbindungsstück (30), das den Wärmeübertrager (18) und den Wärmeabgabekörper (28) miteinander verbindet und sich entlang eines nichtgeraden Weges erstreckt, so dass der Wärmewiderstand zwischen dem Wärmeübertrager (18) und dem Wärmeabgabekörper (28) im Vergleich zu einem kürzesten Weg erhöht ist.

8. Heizvorrichtung (10) nach Anspruch 7, wobei der nichtgerade Weg die Form eines L, U, V, S, Z, N, M oder W hat.

9. Heizvorrichtung (10) nach einem der vorangehenden Ansprüche, wobei die Steuereinrichtung (26) ein Leistungstransistor ist.

10. Heizvorrichtung (10) nach einem der vorangehenden Ansprüche, wobei auf dem Wärmeabgabekörper (28) eine elektrisch isolierende Isolationsschicht (36) und auf der Isolationsschicht (36) eine elektrisch leitende Leitungsschicht (38) jeweils unmittelbar aufgetragen ist, und wobei die Steuereinrichtung (26) auf der Leitungsschicht (38) befestigt ist.

11. Heizvorrichtung (10) nach Anspruch 10, wobei die Steuereinrichtung (26) auf der elektrisch leitenden Leitungsschicht (38) über wenigstens eine Lötkugel (40), ein Klebeelement, ein graphithaltiges Material, eine Wärmeleitfolie, eine Klemmverbindung oder eine Schraubverbindung befestigt ist.

## Claims

1. A heating device (10) for a vehicle, comprising:
- a flow path (14, 16, 20, 22, 24) for a liquid heat transport medium;
- an electric heating unit (34) for generating heat and a heat transfer unit (18) for transferring heat from the heating unit to the heat transport medium on a heating section (20) of the flow path; and
- an electronic control unit (26) for controlling a heating power of the heating unit;
- wherein the control unit (26) is provided with a heat discharge body (28) for discharging waste heat from the control unit (26) to the heat transport medium on a preheating section (16) of the flow path upstream of the heating section (20);
**characterized in that** the heat transfer unit (18) and the heat discharge body (28) are formed in a single piece.

2. The heating device (10) of claim 1, comprising an air heat exchanger for transferring heat from the heat transport medium downstream of the heating section (20) to air.

3. The heating device (10) of claim 1 or 2, comprising a wall which defines the flow path in the preheating section (16) at least partially, wherein the heat discharge body (28) extends from the wall into the preheating section (16).

4. The heating device (10) of claim 3, wherein the heat discharge body (28) extends to an opposite part of the wall.

5. The heating device (10) of claim 3 or 4, wherein the heat discharge body (28) and the wall are formed in a single piece.

6. The heating device (10) of one of the preceding claims, comprising a second electronic control unit (26), wherein the heat discharge body (28) of the first control unit (26) extends to the second control unit (26).

7. The heating device (10) of claim 5 or 6, comprising a connecting piece (30) which connects the heat transfer unit (18) and the heat discharge body (28) to each other and which extends along a non-straight line so that the thermal resistance between the heat transfer unit (18) and the heat discharge body (28) is increased compared to a shortest line.

8. The heating device (10) of claim 7, wherein the non-straight line is shaped as an L, U, V, S, Z, N, M, or W.

9. The heating device (10) of one of the preceding claims, wherein the control unit (26) is a power transistor.

10. The heating device (10) of one of the preceding claims, wherein an electrically isolating isolation layer (36) is applied directly on the heat discharge body (28) and an electrically conductive conduction layer (38) is applied directly on the isolation layer (36), and wherein the control unit (26) is attached on the conduction layer (38).

11. The heating device (10) of claim 10, wherein the control unit (26) is attached on the electrically conductive conduction layer (38) via at least a solder ball (40), an adhesive element, a graphitic material, a conduction foil, a clamp connection, or a screw connection.

## Revendications

1. Dispositif de chauffage (10) pour un véhicule, comprenant :
- un trajet d'écoulement (14, 16, 20, 22, 24) pour un fluide caloporteur liquide ;
- un dispositif de chauffage électrique (34) pour produire de la chaleur et un échangeur de chaleur (18) pour transférer de la chaleur du dispositif de chauffage (34) au fluide caloporteur sur une section de chauffage (20) du trajet d'écoulement ; et
- un dispositif de commande électronique (26) pour commander une puissance calorifique du dispositif de chauffage, dans lequel le dispositif de commande (26) est pourvu d'un corps de distribution de chaleur (28) pour distribuer de la chaleur dégagée par le dispositif de commande (26) au fluide caloporteur sur une section de préchauffage (16) du trajet d'écoulement en amont de la section de chauffage (20) ;
**caractérisé en ce que** l'échangeur de chaleur (18) et le corps de distribution de chaleur (28) sont constitués d'une seule pièce.

2. Dispositif de chauffage (10) selon la revendication 1, comprenant un échangeur de chaleur à air pour transférer de la chaleur du fluide caloporteur en aval de la section de chauffage (20) à l'air.

3. Dispositif de chauffage (10) selon la revendication 1 ou 2, comportant une paroi définissant au moins partiellement le trajet d'écoulement dans la section de préchauffage (16), dans lequel le corps de distribution de chaleur (28) s'étend depuis la paroi vers la section de préchauffage (16).

4. Dispositif de chauffage (10) selon la revendication 3, dans lequel le corps de distribution de chaleur (28) s'étend jusqu'à une partie opposée de la paroi.

5. Dispositif de chauffage (10) selon la revendication 3 ou 4, dans lequel le corps de distribution de chaleur (28) et la paroi sont constitués d'une seule pièce.

6. Dispositif de chauffage (10) selon l'une des revendications précédentes, comprenant un second dispositif de commande électronique (26), dans lequel le corps de distribution de chaleur (28) s'étend du premier dispositif de commande (26) jusqu'au second dispositif de commande (26).

7. Dispositif de chauffage (10) selon la revendication 5 ou 6, comprenant un raccord (30) reliant l'un à l'autre l'échangeur de chaleur (18) et le corps de distribution de chaleur (28) et s'étendant le long d'un trajet non rectiligne de telle sorte que la résistance thermique entre l'échangeur de chaleur (18) et le corps de distribution de chaleur (28) est augmentée par rapport à un trajet le plus court.

8. Dispositif de chauffage (10) selon la revendication 7, dans lequel le trajet non rectiligne est en forme de L, U, V, S, Z, N, M ou W.

9. Dispositif de chauffage (10) selon l'une des revendications précédentes, dans lequel le dispositif de commande (26) est un transistor de puissance.

10. Dispositif de chauffage (10) selon l'une des revendications précédentes, dans lequel une couche d'isolation électrique (36) est appliquée directement sur le corps de distribution de chaleur (28) et une couche de conduction électriquement conductrice (38) est respectivement appliquée directement sur la couche d'isolation (36), et dans lequel le dispositif de commande (26) est fixé sur la couche de conduction (38).

11. Dispositif de chauffage (10) selon la revendication 10, dans lequel le dispositif de commande (26) est fixé à la couche de conduction électriquement conductrice (38) par l'intermédiaire d'au moins une bille de soudure (40), d'un élément adhésif, d'un matériau contenant du graphite, d'une feuille thermiquement conductrice, d'une liaison par serrage ou d'une liaison par vis.
